# EUROPEAN PATENT SPECIFICATION

(11) **EP 0 471 085 B1**
(45) Date of publication and mention of the grant of the patent: **07.05.1997**
(21) Application number: 91904805.8
(22) Date of filing: 28.02.1991
(51) Int. Cl.: H03M 13/00

(54) **ERROR-CORRECTING ENCODING AND DECODING METHOD AND SYSTEM USING A PRODUCT CODE AND A SUPERIMPOSED CODE**
FEHLERKORRIGERENDES KODIER- UND DEKODIERSYSTEM MIT EINEM AUF EINEM PRODUKTKODE ÜBERSCHRIEBENEN KODE SOWIE VERFAHREN DAZU
SYSTEME ET METHODE DE CODAGE ET DE DECODAGE CORRECTEURS D'ERREURS UTILISANT UN CODE PRODUIT ET UN CODE SUPERPOSE

(30) Priority: 02.03.1990 JP 51111/90; 25.04.1990 JP 109864/90
(43) Date of publication of application: 19.02.1992
(73) Proprietor: MITSUBISHI DENKI KABUSHIKI KAISHA, Tokyo 100 (JP)
(72) Inventor: INOUE, Tohru, Mitsubishi Denki Kabushiki Kaisha, Kamakura-shi, Kanagawa 247 (JP); YOSHIDA, Hideo, Mitsubishi Denki Kabushiki Kaisha, Kamakura-shi, Kanagawa 247 (JP)
(74) Representative: Reitzle, Helmut, Dr.
(86) International application number: PCT/JP91/00266
(87) International publication number: WO 91/13496

(56) References cited:
- GB-A- 2 180 966
- JP-A- 5 641 514
- JP-A-63 185 124
- JP-A-63 185 125
- US-A- 4 665 537
- IEEE TRANSACTION ON INFORMATION THEORY, Vol. IT-22, No.4, Jul. 76, Kasahara et al.: "New Classes of Binary Codes Constructed on the Basis of Concatened Codes and Product Codes", p. 462-468.

## Description

### TECHNICAL FIELD

The present invention relates to a method for realizing an error-correction encoding and/or decoding for processing an error-correcting code made by superimposing error-correcting codes respectively generated from a couple of pieces of information.

### BACKGROUND ART

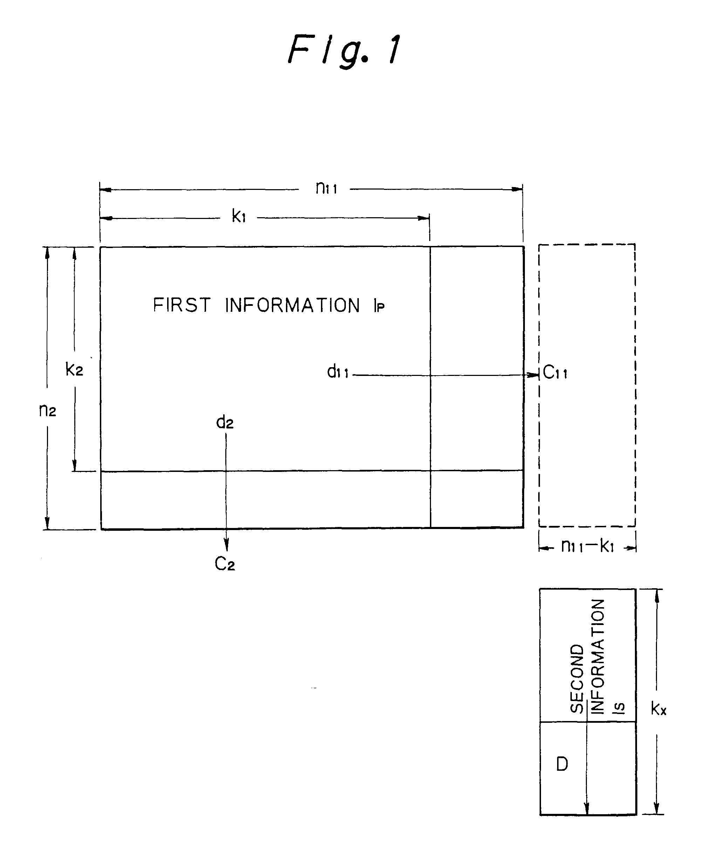

Fig. 1 shows an example of a code format in encoding by utilizing a product code first information Iₚ which is required to be highly reliable and second information Iₛ which is not required to have such a high reliability, which example is described in "Error-Correcting Codes" written by Peterson et al., MIT Press, 1972, p.131-136. As shown in Fig. 1, first information Iₚ of k₁ × k₂ digits is encoded by a product code. Namely, this first information is encoded to a product code comprising, as partial codes, a linear code C₁₁ having a code word length n₁₁, information code length k₁ and minimum code length d₁₁ (hereinafter a linear code C of code word length N, information code length k and minimum code length D will be called a (N, K, D) linear code C. For example, the above linear code C₁₁ is expressed by (n₁₁, k₁, d₁₁) linear code C₁₁) and a (n₂, k₂, d₂) linear code C₂ and the composite minimum distance is expressed by d₁₁ × d₂. On the other hand, second information Iₛ of r × kₓ digit (r ≦ n₁₁ - k₁) is encoded to a block code. For instance, second information Iₛ is encoded to a (n₂, kₓ, D) linear code C₃ on a Galois field GF(2^{r}). In this case, the product code and linear code C₃ are not superimposed with each other and are transmitted separately. In a receiving side, a received word of the product code and linear code C₃ are decoded to recover predetermined information.

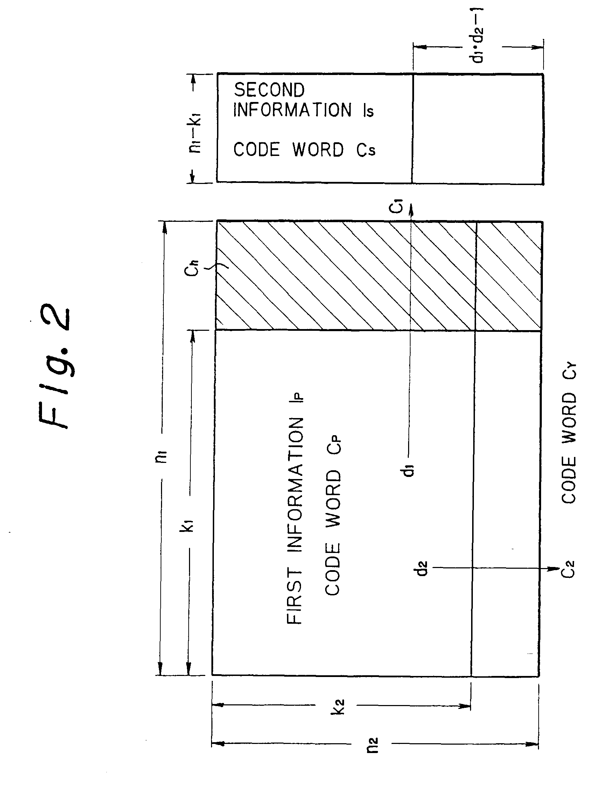

Fig. 2 shows an example of a code format in encoding first information Iₚ and second information Iₛ s using a superimposed code, introduced, for example, by M. Kasahara, et al.: "New Classes of Binary Codes Constructed on the Basis of Concanated Codes and Product Codes", IEEE Transaction on Information Theory, Vol. IT - 22, No. 4 (July 1976), p.462-468. In this case, first information Iₚ is encoded to a product code of the compound minimum distance d₁·d₂ by using the partial codes of first information, i.e., (n₁, k₁, d₁) linear code C₁ and (n₂, k₂, d₂) linear code C₂. Meanwhile, second information Iₛ of (n₁ - k₁) × (n₂ - (d₁·d₂ - 1)) digits is encoded by an RS (Reed-Solomon) code on GF(2^{r}) of the minimum distance d₁·d₂ - 1. Here, r = n₁ - k₁ and a code word Cₛ of the RS code is superimposed on a check field Cₕ (hatched portion in Fig. 2) of the product code.

Next, an encoding operation will be explained. First information Iₚ is encoded to a product code, while second information Iₛ to an(n₂, n₂ - d₁·d₂ + 1, d₁·d₂ - 1) RS code on GF(2^{r}). When a code word of the product code is assumed as Cₚ and a code word of the RS code as Cₛ, code word Cₛ is superimposed on a C₁ code check field Cₕ of code word Cₚ (Cₕ is assumed to include a check field of linear code C₁ and a check field for this check field). Therefore, a code word C_{y} after such superimposing is transmitted to a transmission line.

Here, the i-th symbol Rᵢ of code word Cₛ is expressed as Rᵢ = (Rᵢ₁, Rᵢ₂, ....., Rᵢᵣ), and Mᵢ is defined as follows: ${\text{M}}_{\text{i}} {\text{= H}}_{\text{i}} {\text{⊕ R}}_{\text{i}} {\text{= H}}_{\text{i1}} {\text{⊕ R}}_{\text{i1}} {\text{, H}}_{\text{i2}} {\text{⊕ R}}_{\text{i2}} {\text{, ....., H}}_{\text{ir}} {\text{⊕ R}}_{\text{ir}} \text{)}$ ⊕ means modulo-2 sum and Hᵢ designates a symbol of check field Cₕ. Moreover, Fᵢ is defined as follows:

Fᵢ = (Iᵢ, Mᵢ)

Iᵢ is an information symbol of linear code C₁. Therefore, code word C_{y} after the superimposing is expressed as a vector (F₁, F₂, ....., F_{q}) where q = n₂.

In addition, the article in the IEEE cited above shows the following theorem:

Theorem: In case a product code is capable of correcting up to ten (10) errors, a code after the superimposing can correct t-fold random errors when the minimum distance D₁ of a superimposed code (the compound code explained above) satisfies the relationship t = (D₁ - 1)/2.

Next, a decoding operation will be explained. Here, reencoding of a received information symbol series of a basic code (the product code mentioned above) for the purpose of separating a received word of the basic code and a superposed code is called "separation encoding". Further, internal check recovery by separation encoding is called "internal check recovery", while separation of a superimposed received word by modulo-2 sum of an internal check symbol and a received word is called "superimposing separation". An error newly added to a superimposed code word at the time of superimposing separation due to an error generated at the information symbol of the basic code is called a "pseudo-error". This pseudo-error coincides with a syndrome.

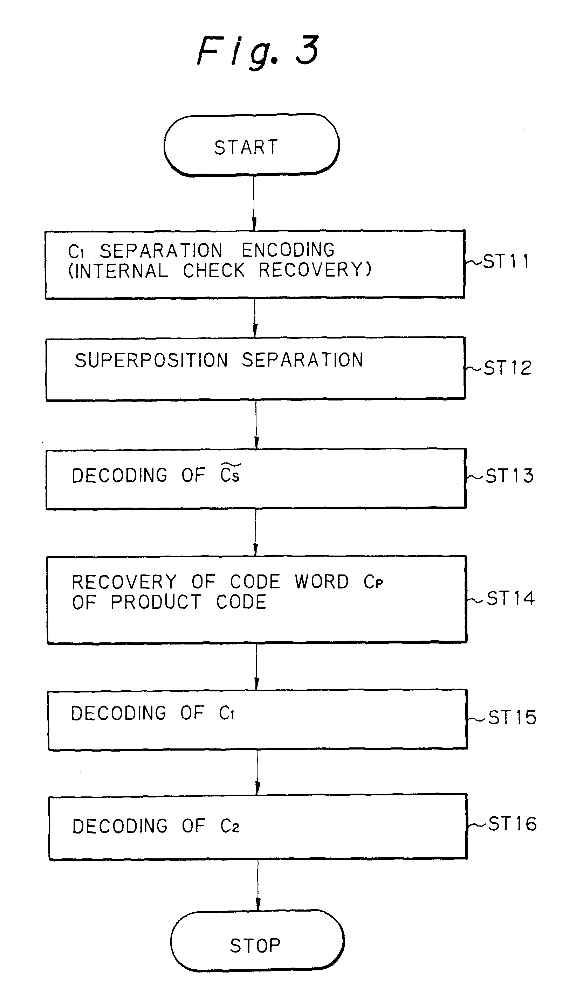

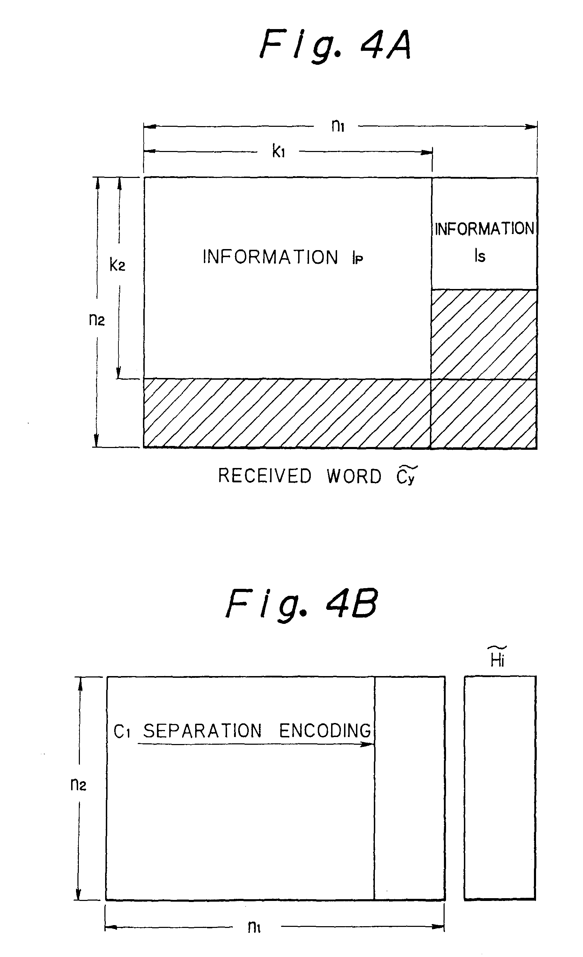

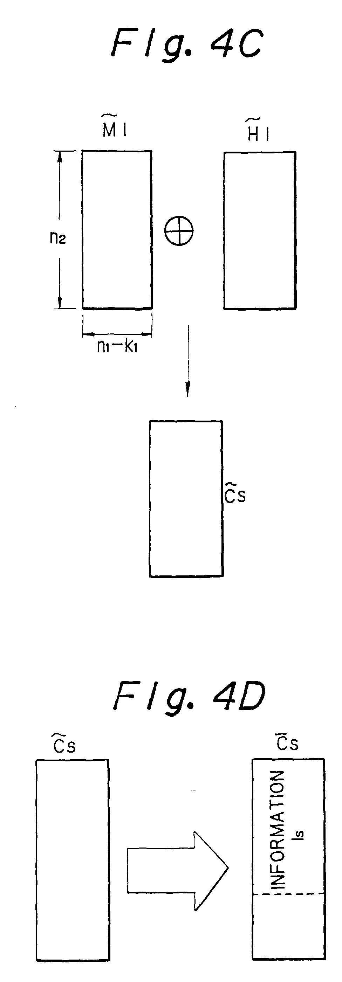

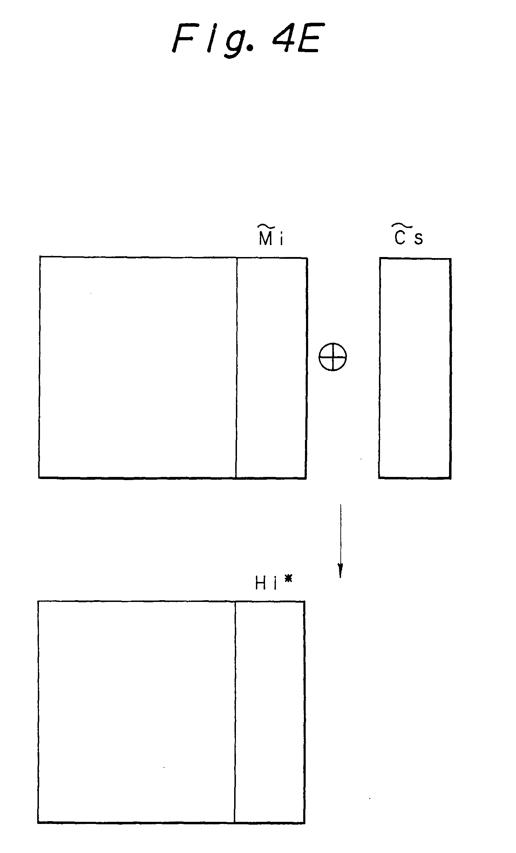

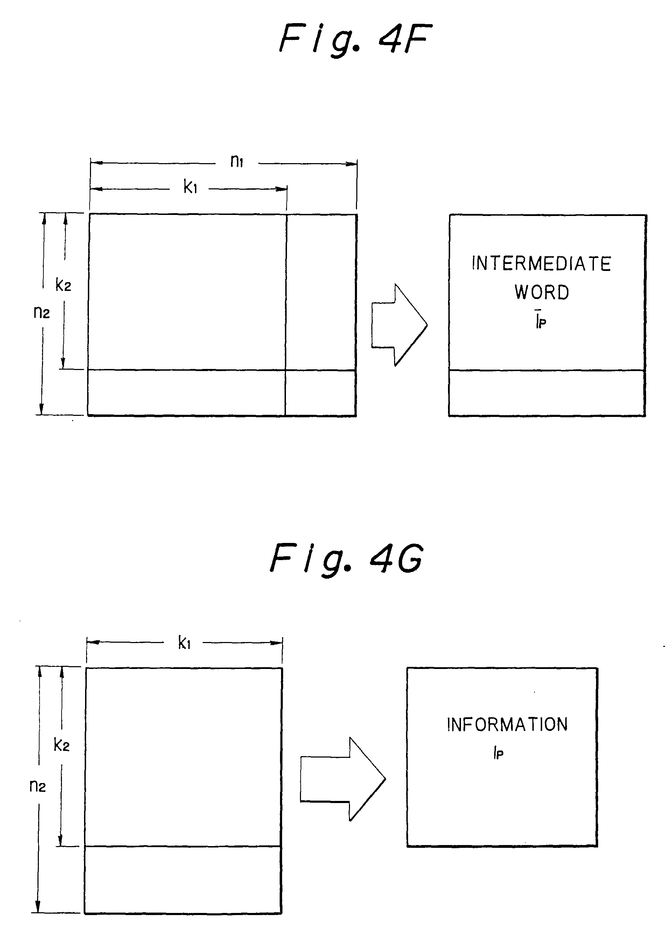

Further a detailed explanation will be made with reference to a flowchart of Fig. 3 and an explanatory drawing of Fig. 4. A received word 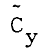 is shown in Fig. 4(a). In this figure, the hatched area indicates a redundant field. First, as shown in Fig. 4(B), C₁ separation encoding is carried out for each line of n₂ lines in a C₁ separation-encoding routine (step ST11) to obtain an internal check recovery symbol 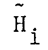 . Next, in a superimposing separation routine (step ST12), as shown in Fig. 4(C), internal check recovery symbol Hᵢ is modulo-2 summed with a check field 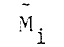 of received word C_{y} in order to separate a received word 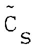 of the superimposed code. In a superimposed code decoding routine (step ST13), received word 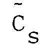 is decoded to obtain a decoded word $\overline{\text{C}}$ₛ and information Iₛ is output as shown in Fig. 4(D).

Moreover, a received word 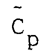 of the product code is separated in a product code recover routine (step ST14) by modulo-2 summing decoded word $\overline{\text{C}}$ₛ with check field 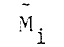 . of received word 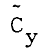 . At this time, as shown in Fig. 4(E), a C₁ code check field Hᵢ* of the product code is recovered. Next, received word 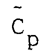 is decoded in a C₁ decoding routine (step ST15) to obtain an intermediate received word $\overline{\text{I}}$ₚ as shown in Fig. 4(F). Intermediate received word $\overline{\text{I}}$ₚ is decoded and information Iₚ as shown in Fig. 4(G) is output in a C₂ decoding routine (step ST16).

In the case where first information Iₚ encoded with a product code is not superimposed by information obtained by encoding second information Iₛ in the encoding and decoding operations explained with reference to Fig. 1, such a problem exists that sufficient error-correcting capability cannot be exerted if error-correction encoding is not carried out by providing wide check field because encoding is conducted with a code perfectly separating information Iₚ and Iₛ.

Although the encoding and decoding explained with reference to Figs. 2-4 can remarkably reduce redundancy of a product code if the code word of information Iₛ is superimposed on the check field of the product code, but the minimum distance of the superimposed code must be set as large as d₁·d₂ - 1 in order to transmit information Iₛ, thereby necessitating complicated hardware structure.

Furthermore, since the product code and the superimposed code must be separated at the time of decoding if the code word of information Iₛ is superimposed on the product code, after internal check recovery symbol 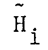 is generated by executing separation encoding, received word 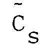 of the superimposed code is further separated from internal check recovery symbol 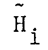 and received word 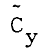 and the product code must be recovered by adding again decoded word $\overline{\text{C}}$ₛ obtained from received word 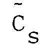 to received word 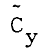 . Consequently, very complicated processings are required to be conducted to finally obtain information Iₚ and Iₛ as well as a longer decoding time required.

### DISCLOSURE OF INVENTION

It is a general object of the present invention to solve the problems explained above.

It is another object of the present invention to provide an error-correction encoding and/or decoding method which can reduce any influence from pseudo-error during superimposing separation and which is also capable of setting reliability of second information to a desired value independent of a reliability of first information.

It is a further object of the present invention to provide an error-correction encoding and decoding method which is capable of enhancing error-correcting capability of a superimposed code Uₛ up to 2 times as high as a conventional decoding system and which can transmit second information, if it is transmitted with a reliability similar to that in the conventional decoding system, with a redundancy substantially equal to half of that in the conventional decoding system.

According to the present invention an error-correction method is provided, comprising (i) encoding, in a first direction, a first information of k₁ x k₂ digits having k₁ digits in the first direction and k₂ digits in a second direction to a first linear code (n₁, k₁, d₁) having a check symbol of (n₁ - k₁) digits and the minimum distance d₁, (ii) encoding the first linear code in the second direction to a second linear code having a check symbol of (n₂ - k₂) digits and the minimum distance d₂, (iii) thus resulting in encoding the first information to a product code C_{A} of n₁ x n₂ digits, (iv) encoding a second information of the r x kₓ digits where r is smaller than the number of digits of the check symbol in the first direction and where kₓ is smaller than the code length of the second linear code, to a third linear code of the minimum distance d₃, and (v) generate a composite code by superimposing a code word of the third linear code on a field on which the check symbol in the first or second direction of the product code is disposed.

Further, according to the present invention an error -correction decoding method is provided comprising receiving a code word of a composite code generated as pointed out above as received word, decoding the composite code in the first direction to output the third linear code, decoding the third linear code to output the second information, and decoding the third linear code in the first direction to output the first information.

### BRIEF DESCRIPTION OF DRAWING

Fig. 1 is a structural diagram indicating the structure of a conventional code word utilizing a product code and a block code;
Fig. 2 is a structural diagram indicating the structure of a conventional code word utilizing a code superimposition;
Fig. 3 is a flowchart indicating a conventional decoding method;
Fig. 4 is a diagram for explaining a conventional decoding operation;
Fig. 5 is a block diagram indicating the structure of an encoder to be used for an error-correction encoding and decoding system according to an embodiment of the present invention;
Fig. 6 is a structural diagram indicating an example of the structure of a code word;
Fig. 7 is a block diagram indicating the structure of a decoder for an error-correcting code encoded by the encoder of Fig. 5;
Fig. 8 is a flowchart indicating a decoding method performed in the decoder of Fig. 7;
Fig. 9 is a diagram for explaining a decoding operation of the decoder of Fig. 7; and
Fig. 10 is a diagram for explaining operations of an improved error-correction encoding and decoding system of the present invention.

### DESCRIPTION OF PREFERRED EMBODIMENTS OF THE INVENTION

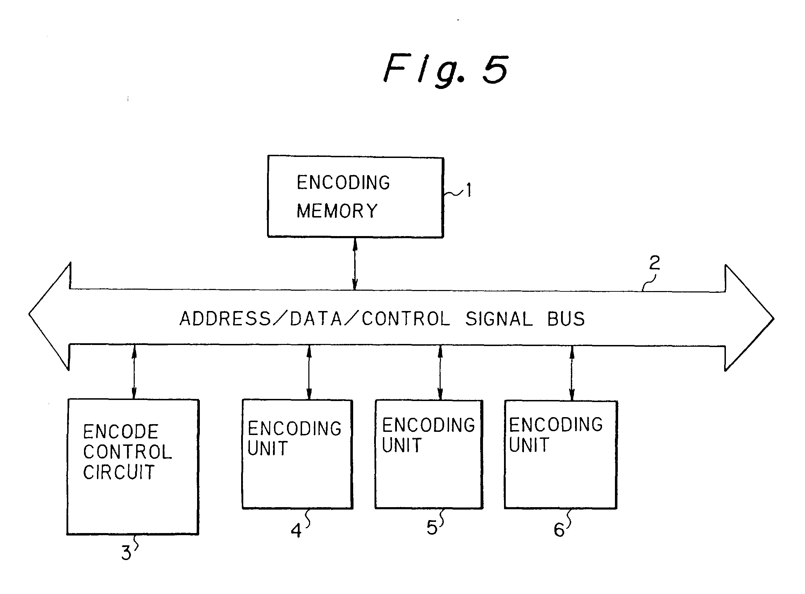

Some embodiments of the present invention will be explained hereunder. Fig. 5 is a block diagram indicating the structure of an embodiment of an encoder for realizing an error-correction encoding and decoding system according to the present invention. In this figure, the reference numeral 1 denotes an encoding memory for storing information Iₚ (first information) and information Iₛ (second information); 2, an address/data/control signal bus (hereinafter referred to as bus); 3, an encode control circuit; 4, a C₁ encoding unit (first encoding unit) for performing the encoding in the row direction (first direction); 5, a C₂ encoding unit (second encoding unit) for performing the encoding in the column direction (second direction); 6, a C₃ encoding unit (third encoding unit) for encoding a superimposed code (third linear code).

It is assumed that the first information has k₁ × k₂ digits, the second information Iₛ having r × kₓ digits (where r is an adequate number satisfying the relationship r < n₁ - k₁ and kₓ is an adequate number satisfying the relationship kₓ < n₂).

Next, an operation of the encoder shown in Fig. 5 will be explained. Information Iₚ of k₁ × k₂ digits stored in encoding memory 1 is input for each set of k₁ digits to C₁ encoding unit 4 under the control of encode control circuit 3. The encoding is carried out for each input digit and a code word of n₁ digits is generated. This processing is repeated k₂ times and an intermediate code word of k₂ × n₁ digits is generated. In addition, the intermediate code word is input for each set of k₂ digits to C₂ encoding unit 5 under the control of encode control circuit 3. Encoding is carried out for each input digit to generate a code word of n₂ digits. The processing is repeated n₁ times to generate a code word of a product code C_{A} of n₁ × n₂ digits.

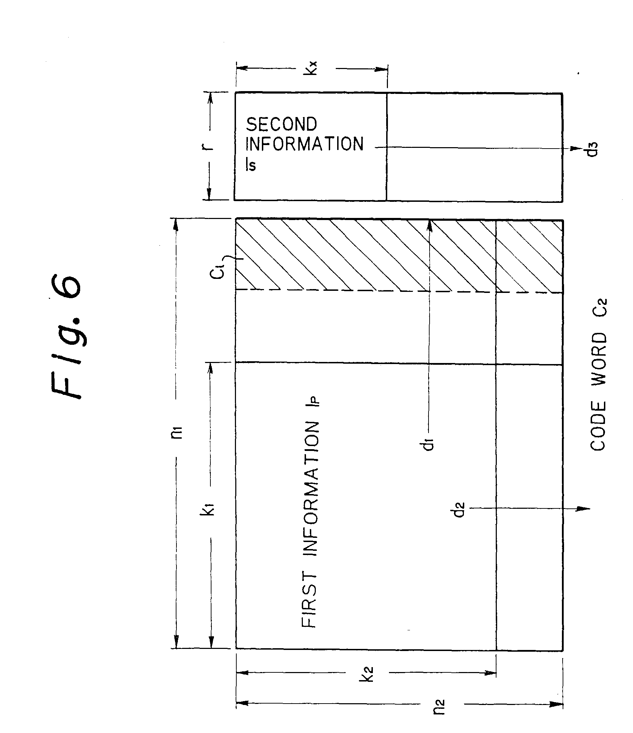

Meanwhile, information Iₛ of r × kₓ digits stored in encoding memory 1 is encoded by C₃ encoding unit 6 to a (n₂, kₓ, d₃) linear code (superimposed code Uₛ) having the minimum distance d₃ to generate a code word. A code word Cₛ of superimposed code Uₛ is superimposed on a part C_{ℓ} (hatched portion in Fig. 6) in the row direction of the code word of the product code through bus 2 under the control of encode control circuit 3. Finally, an error-correcting code word C_{z} is generated. The structure of error-correcting code word C_{z} is shown in Fig. 6.

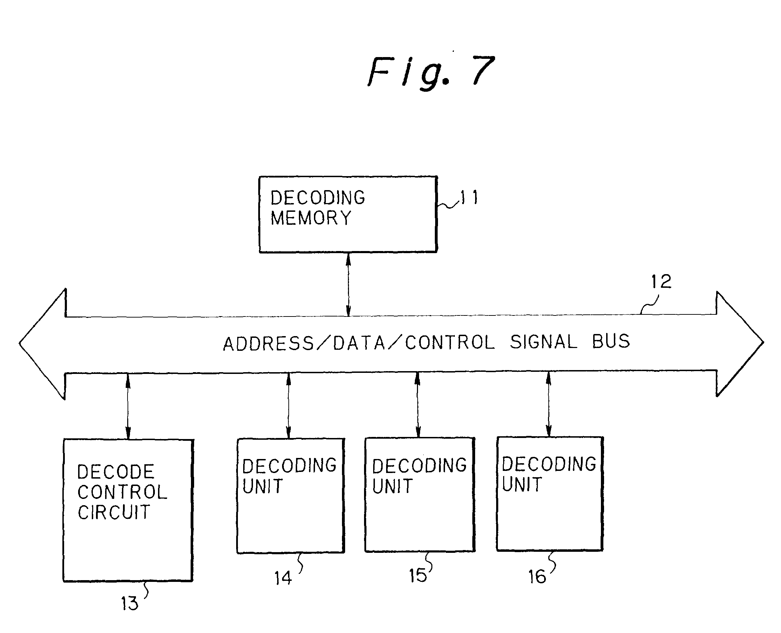

Fig. 7 is a block diagram indicating the structure of an embodiment of a decoder for decoding the code word encoded by the encoder of Fig. 5. In Fig. 7, the reference numeral 11 denotes a decoding memory for recovering a received word; 12 an address/data/control signal bus; 13 a decode control circuit for controlling each unit through address/data/control signal bus 12 and executing a decoding operation; 14 a C₁ decoding unit for decoding a received word C₁ which is a partial code word of received product code C_{A}; 15 a C₂ decoding unit for decoding a received word C₂; 16 a C₃ decoding unit for executing elimination/error decoding of superposed received word C₃ after superimposing and separating superimposed received word C₃ from the superimposing field of received error-correcting code C_{z} stored in decoding memory 11.

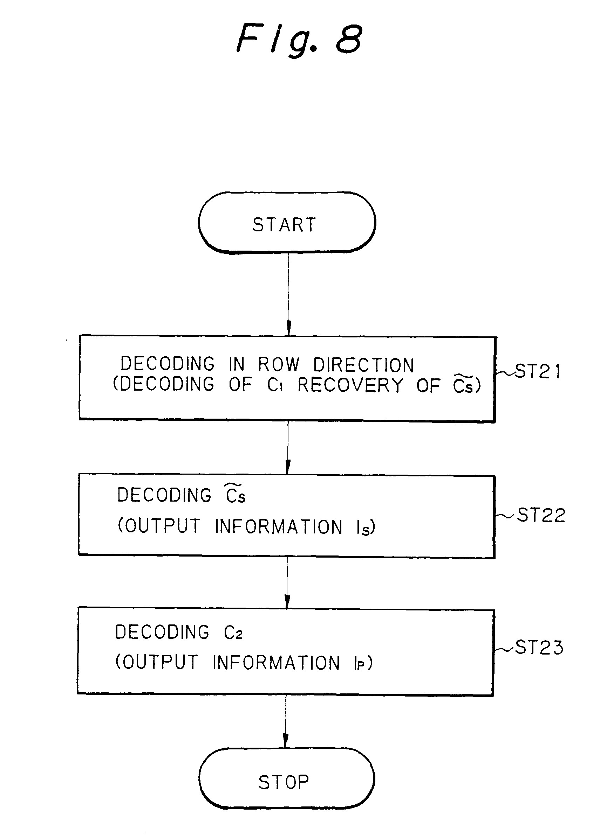

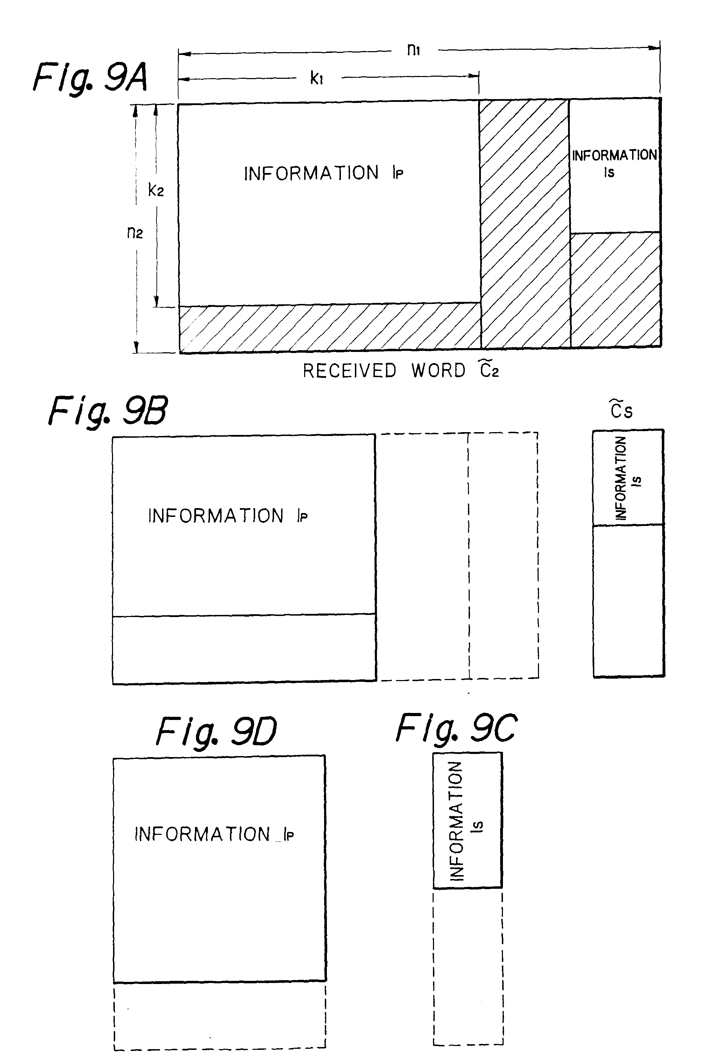

An operation of the decoder shown in Fig. 7 will then be explained with reference to a flowchart of Fig. 8 and an explanatory diagram of Fig. 9. A received word (hereinafter a received code or code word is only called a received word) 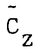 of n₁ × n₂ digits received from the transmission line and stored in decoding memory 11 is then input to C₁ decoding unit 14 by a command of decode control circuit 13. The structure of received word 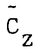 is shown in Fig. 9(A). C₁ decoding unit 14 considers a field of r × n₂ digits on which a code Uₛ is superimposed as an elimination pattern and received word C₁ is decoded n₂ times (step ST21). Namely, decoding is carried out for each of n₂ rows. At this time, r superimposed symbols are considered as eliminated symbols and t errors and r eliminations are corrected in the range where 2t + r < d . As a result of this correction, when n₂ received words in the row direction have been decoded, a recovered elimination error pattern becomes a received word 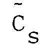 of code word Cₛ of superimposed code Uₛ (code word Cₛ plus transmission line error), namely, received word 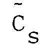 is superimposed and separated from received error-correcting code C_{z} (refer to Fig. 9(B)).

Next, receiving word 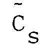 is decoded by C₃ decoding unit 16 (step ST22) to output information Iₛ (refer to Fig. 9(C)). Also, C₂ decoding unit 15 repeatedly decodes those decoded by C₁ decoding unit 14 n₁ times (step ST23) thereby completing the decoding of the product code and outputs information Iₚ (refer to Fig. 9(D)).

In the above embodiment, an example where a code word of a superimposed code is superimposed on the check symbol field of the codes in the row direction of the product code has been explained, but a similar advantages can also be obtained by superimposing such a code word on the check symbol field of the codes in the column direction.

As will be understood from the above explanation, the present invention is advantageous in that, since an encoder for an error-correcting code is structured to superimpose a code word of a superimposed code only on a part of the check symbol field of a product code, an error correcting capability of the superimposed code can be arbitrarily set and a received word of the superimposed code can simultaneously be recovered in a decoding side at the time of decoding the product code in one direction.

Moreover, the present invention is advantageous in that, since a decoder for an error-correcting code is structured to receive a code word made by superimposing a code word of the superimposed code only on a part of the check symbol field of the product code so as to recover a received word of the superimposed code at the time of decoding the product code in one direction, any influence of pseudo-error can be prevented without any necessity of superimposing and separating the product code and the superimposed code and high speed decoding can be achieved.

The present invention is further advantageous in that, since the part on which a code word of a superimposed code is superimposed at the time of decoding a product code in one direction is decoded as eliminated digits, a received word of the superimposed code can be simultaneously recovered, high speed decoding can be achieved and any restriction to the error-correcting capability of a superimposed code can be removed.

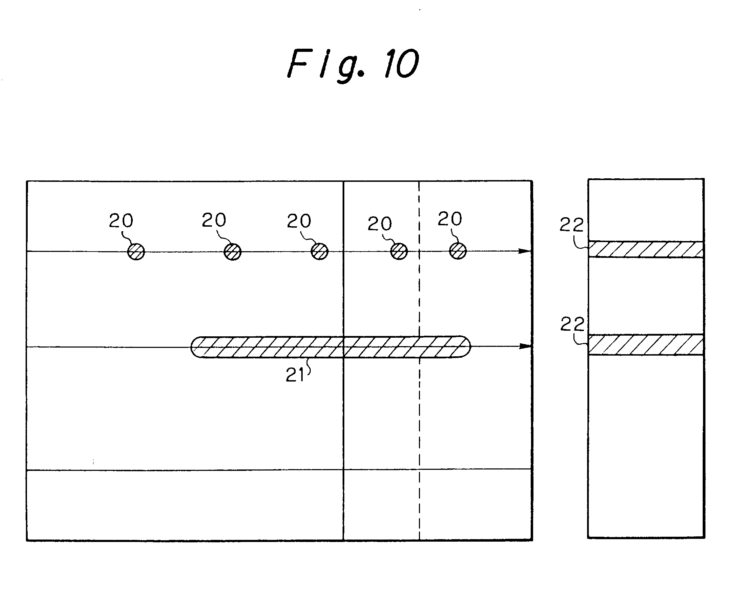

In the error-correction decoding system explained with reference to Fig. 7 - Fig. 9, correct second information Iₛ can be obtained as long as superimposed code Uₛ has sufficient error-correcting capability. Namely, recovered superimposed received word Cₛ can be obtained as an elimination pattern in decoding received word C₁, but the obtained elimination pattern is a result obtained by modulo-2 summing superimposed code Uₛ with errors generated on this superimposed code Uₛ. Therefore, if decoding of received word C₁ is not carried out correctly, an elimination pattern cannot be recovered correctly, resulting in an error (not elimination but pure error) of recovered superimposed received word Cₛ. However, as shown, for example, in Fig. 10, in the case where random error 20 and burst error 21 exceeding the correcting capability of received word C₁ are generated, an elimination flag 22 is output with respect to superimposed received word Cₛ when it is judged that correction is impossible by a syndrome of C₁ decoding unit 14 or when correction is possible but reliability is low. Superimposed received word Cₛ thus recovered is corrected as an elimination symbol by C₃ decoding unit because no symbol is recovered at the point where elimination flag 22 is set. Such operations as described above are carried out based on instructions of decode control circuit 13.

Assuming that the minimum distance of superimposed code Uₛ is D, that S eliminations are generated by decoding received word C₁ and that recovered superimposed received code Cₛ includes nₑ error symbols due to error correction of receiving word C₁ or overlooked error, nₑ errors and S eliminations can be corrected in the range where 2nₑ + S < D When all errors in decoding received word C₁ can successfully be corrected (namely nₑ = 0), S becomes equal to (D - 1) indicating that error correction as high as 2-fold of that in the ordinary correction can be realized.

In an embodiment of the present invention, the first information of k₁ × k₂ digits is converted to a linear code of (n₂ - k₂) digits in the second direction with the minimum distance d₂, but it is possible to construct an encoder which generates a composite code by linearly encoding the second information of r × kᵣ digits in the second direction for superimposition and a decoder which decodes the first and second information from the received word encoded by the encoder, if the first information is comprised of k₁ × n₂ digits and no linear encoding is performed in the second direction.

As explained above, an elimination flag is added to a relevant symbol of a corresponding superimposed received word Cₛ by utilizing decoding information of a received word C₁, and elimination error decoding is conducted on a recovered superimposed received word Cₛ. Accordingly, the error-correcting capability of an error-correcting code Uₛ of a superimposed code Uₛ can be enhanced up to 2 times in comparison with that of a conventional decoding system. Further, in the case of transmission of information having a reliability similar to that of the conventional system, an error-correction decoding system which can transmit the second information with a redundancy of about half of that in the conventional decoding system can be realized.

## Claims

1. Error-correction encoding method comprising
(i) encoding, in a first direction, a first information of k₁ x k₂ digits having k₁ digits in the first direction and k₂ digits in a second direction to a first linear code (n₁, k₁, d₁) having a check symbol of (n₁ - k₁) digits and the minimum distance d₁,
(ii) encoding the first linear code in the second direction to a second linear code having a check symbol of (n₂ - k₂) digits and the minimum distance d₂,
(iii) thus resulting in encoding the first information to a product code C_{A} of n₁ x n₂ digits,
(iv) encoding a second information of the r x kₓ digits where kₓ is smaller than the code length of the second linear code, to a third linear code of the minimum distance d₃, and
(v) generate a composite code by superimposing a code word of the third linear code on a field on which the check symbol in the first or second direction of the product code is disposed,
**characterized** in that the number of digits r is smaller than the number of digits of the check symbol in the first direction.

2. Error-correction decoding method for decoding a code word of a composite code generated by
encoding, in a first direction, a first information of k₁ x k₂ digits having k₁ digits in the first direction and k₂ digits in a second direction to a first linear code (n₁, k₁, d₁) having a check symbol of (n₁ - k₁) digits and the minimum distance d₁,
encoding the first linear code in the second direction to a second linear code having a check symbol of (n₂ - k₂) digits and the minimum distance d₂,
thus resulting in encoding the first information to a product code C_{A} of n₁ x n₂ digits,
encoding a second information of the r x kₓ digits where r is smaller than the number of digits of the check symbol in the first direction and where kₓ is smaller than the code length of the second linear code, to a third linear code of the minimum distance d₃, and
superimposing a code word of the third linear code on a field on which the check symbol in the first or second direction of the product code is disposed,
receiving the code word as received word, decoding the composite code in the first direction to output the first linear code, decoding the third linear code to output the second information, and decoding the first linear code in the first direction to output the first information.

3. Decoding method according to claim 2,
wherein the code word of the composite code in the first direction is decoded by considering the digits on which the code word of the third linear code is superposed as elimination digits, and obtaining a recovered elimination/error pattern.

4. An error correction encoding and decoding method, comprising
the encoding method of claim 1 and the decoding method of claim 2 or 3.

5. An encoder for carrying out the coding method of claim 1, comprising
a first encoding unit (4) for encoding a first information of k₁ x k₂ digits with k₁ digits in the first direction and k₂ digits in the second direction to the first linear code having the check symbol of (n₁ - k₁) digits with the minimum distance d₁,
a second encoding unit (15) for encoding the first linear code, in the second direction, to the second linear code having the check symbol of (n₂ - k₂) digits with the minimum distance d₂, thereby encoding the first information to a product code of n₁ x n₂ digits,
the encoder further comprising a third encoding unit (16) for encoding the second information of r x kₓ digits which is a product of the number of digits r and the number of digits kₓ which is shorter than the code length of the second linear code to the third linear code of the minimum distance d₃, and
an encode control circuit (3) for generating a composite code by superimposing a code word of the third linear code on a field on which the check symbol in the first direction of the product code is disposed,
**characterized** in that
the number of digits r is smaller than the number of digits of the check symbol in the first direction.

6. A decoder for carrying out the decoding method of claim 2 for decoding a code word of a composite code generated by
encoding, in a first direction, a first information of k₁ x k₂ digits having k₁ digits in the first direction and k₂ digits in a second direction to a first linear code (n₁, k₁, d₁) having a check symbol of (n₁ - k₁) digits and the minimum distance d₁,
encoding the first linear code in the second direction to a second linear code having a check symbol of (n₂ - k₂) digits and the minimum distance d₂,
thus resulting in encoding the first information to a product code C_{A} of n₁ x n₂ digits,
encoding a second information of the r x kₓ digits where r is smaller than the number of digits of the check symbol in the first direction and where kₓ is smaller than the code length of the second linear code, to a third linear code of the minimum distance d₃, and
superimposing a code word of the third linear code on a field on which the check symbol in the first or second direction of the product code is disposed,
the decoder comprising
a first decoding unit (14) which receives a code word of the composite code as a received word to decode the code of the composite code in the first direction so as to output a received word of the third linear code,
a third decoding unit (16) which decodes the second information from the received word of the output third linear code or the recovered elimination/error pattern, and
a second decoding unit (15) which decodes the first information from the decoding output of first decoding unit.

7. Error-correction encoding and decoding system, comprising
an encoder according to claim 5 and an decoder according to claim 6.

## Patentansprüche

1. Fehlerkorrigierendes Codierverfahren, welches aufweist:
(i) Codieren einer ersten Information von k₁ x k₂ Stellen mit k₁ Stellen in einer ersten Richtung und k₂ Stellen in einer zweiten Richtung in der ersten Richtung zu einem ersten linearen Code (n₁,k₁,d₁) mit einem Prüfsymbol von (n₁-k₁) Stellen und dem minimalen Abstand d₁,
(ii) Codieren des ersten linearen Codes in der zweiten Richtung zu einem linearen Code mit einem Prüfsymbol von (n₂-k₂) Stellen und dem minimalen Abstand d₂,
(iii)wodurch sich eine Codierung der ersten Information zu einem Produktcode C_{A} von n₁ x n₂ Stellen ergibt,
(iv) Codieren einer zweiten Information der r x kₓ Stellen, worin kₓ kleiner als die Codelänge des zweiten linearen Codes ist, zu einem dritten linearen Code des minimalen Abstands d₃, und
(v) Erzeugen eines zusammengesetzten Codes durch Überlagern eines Codewortes des dritten linearen Codes auf einem Feld, auf welchem sich das Prüfsymbol in der ersten oder zweiten Richtung des Produktcodes befindet,
**dadurch gekennzeichnet,** daß die Anzahl von Stellen r kleiner ist als die Anzahl von Stellen des Prüfsymbols in der ersten Richtung.

2. Fehlerkorrigierendes Decodierverfahren zum Decodieren eines Codewortes eines zusammengesetzten Codes, der erzeugt ist durch
Codieren einer ersten Information von k₁ x k₂ Stellen mit k₁ Stellen in einer ersten Richtung und k₂ Stellen in einer zweiten Richtung zu einem ersten linearen Code (n₁,k₁d₁) mit einem Prüfsymbol von (n₁-k₁) Stellen und dem minimalen Abstand d₁,
Codieren des ersten linearen Codes in der zweiten Richtung zu einem zweiten linearen Code mit einem Prüfsymbol von (n₂-k₂) Stellen und dem minimalen Abstand d₂,
wodurch sich eine Codierung der ersten Information zu einem Produktcode C_{A} von n₁ x n₂ Stellen ergibt,
Codieren einer zweiten Information der r x kₓ Stellen, worin r kleiner ist als die Anzahl von Stellen des Prüfsymbols in der ersten Richtung und worin kₓ kleiner ist als die Codelänge des zweiten linearen Codes, zu einem dritten linearen Code des minimalen Abstands d₃, und
Überlagern eines Codewortes des dritten linearen Codes auf einem Feld, auf welchem sich das Prüfsymbol in der ersten oder zweiten Richtung des Produktcodes befindet,
Empfangen des Codewortes als empfangenes Wort,
Decodieren des zusammengesetzten Codes in der ersten Richtung zur Ausgabe des dritten linearen Codes, Decodieren des dritten linearen Codes zur Ausgabe der zweiten Information, und Decodieren des ersten linearen Codes in der ersten Richtung zur Ausgabe der ersten Information.

3. Decodierverfahren nach Anspruch 2, worin das Codewort des zusammengesetzten Codes in der ersten Richtung decodiert wird durch Berücksichtigung der Stellen, auf welche das Codewort des dritten linearen Codes als Eliminierungsstellen überlagert ist, und Erhalten eines wiedergewonnenen Eliminierungs/Fehler-Musters.

4. Fehlerkorrigierendes Codier- und Decodierverfahren, welches das Codierverfahren nach Anspruch 1 und das Decodierverfahren nach Anspruch 2 oder 3 umfaßt.

5. Codierer zum Durchführen des Codierverfahrens nach Anspruch 1, welcher aufweist:
eine erste Codiereinheit (4) zum Codieren einer ersten Information von k₁ x k₂ Stellen mit k₁ Stellen in der ersten Richtung und k₂ Stellen in der zweiten Richtung zu dem ersten linearen Code mit dem Prüfsymbol von (n₁-k₁) Stellen und dem minimalen Abstand d₁,
eine zweite Codiereinheit (15) zum Codieren des ersten linearen Codes in der zweiten Richtung zu dem zweiten linearen Code mit dem Prüfsymbol von (n₂-k₂) Stellen und dem minimalen Abstand d₂,
wodurch die erste Information zu einem Produktcode von n₁ x n₂ Stellen codiert wird,
wobei der Codierer weiterhin eine dritte Codiereinheit (16) aufweist zum Codieren der zweiten Information von r x kₓ Stellen, welche ein Produkt aus der Anzahl von Stellen r und der Anzahl von Stellen kₓ ist, welche kürzer ist als die
Codelänge des zweiten linearen Codes, zu dem dritten linearen Code des minimalen Abstands d₃, und
eine Codiersteuerschaltung (3) zum Erzeugen eines zusammengesetzten Codes durch Überlagern eines Codewortes des dritten linearen Codes auf ein Feld, auf welchem sich das Prüfsymbol in der ersten Richtung des Produktcodes befindet,
**dadurch gekennzeichnet,**
daß die Anzahl von Stellen r kleiner ist als die Anzahl von Stellen des Prüfsymbols in der ersten Richtung.

6. Decodierer zum Durchführen des Decodierverfahrens nach Anspruch 2 zum Decodieren eines Codewortes eines zusammengesetzten Codes, welcher erzeugt wurde durch
Codieren einer ersten Information von k₁ x k₂ Stellen mit k₁ Stellen in einer ersten Richtung und k₂ Stellen in einer zweiten Richtung in der ersten Richtung zu einem ersten linearen Code (n₁,k₁,d₁) mit einem Prüfsymbol von (n₁-k₁) Stellen und dem minimalen Abstand d₁,
Codieren des ersten linearen Codes in der zweiten Richtung zu einem zweiten linearen Code mit dem Prüfsymbol von (n₂-k₂) Stellen und dem minimalen Abstand d₂, wodurch sich eine Codierung der ersten Information zu einem Produktcode C_{A} von n₁ x n₂ Stellen ergibt,
Codieren einer zweiten Information der r x kₓ Stellen, worin r kleiner ist als die Anzahl von Stellen des Prüfsymbols in der ersten Richtung und worin kₓ kleiner ist als die Codelänge des zweiten linearen Codes, zu einem dritten linearen Code des minimalen Abstands d₃, und
Überlagern eines Codewortes des dritten linearen Codes auf ein Feld, auf welchem sich das Prüfsymbol in der ersten oder zweiten Richtung des Produktcodes befindet,
wobei der Decodierer aufweist:
eine erste Decodiereinheit (14), welche ein Codewort des zusammengesetzten Codes empfängt als ein empfangenes Wort zum Decodieren des Codes des zusammengesetzten Codes in der ersten Richtung, um ein empfangenes Wort des dritten linearen Codes auszugeben,
eine dritte Decodiereinheit (16), welche die zweite Information aus dem empfangenen Wort des ausgegebenen dritten linearen Codes oder dem wiedergewonnenen Eliminierungs/Fehler-Muster decodiert, und
eine zweite Decodiereinheit (15), welche die erste Information aus dem Decodier-Ausgangssignal der ersten Decodiereinheit decodiert.

7. Fehlerkorrigierendes Codier- und Decodiersystem, welches einen Codierer nach Anspruch 5 und einen Decodierer nach Anspruch 6 aufweist.

## Revendications

1. Procédé de codage à correction d'erreurs, consistant à :
(i) coder, dans une première direction, une première information de k₁ x k₂ chiffres ayant k₁ chiffres dans la première direction et k₂ chiffres dans une deuxième direction, en un premier code linéaire (n₁, k₁, d₁) ayant un symbole de vérification de (n₁ - k₁) chiffres et la distance minimale d₁ ,
(ii) coder le premier code linéaire dans la deuxième direction en un deuxième code linéaire ayant un symbole de vérification de (n₂ - k₂) chiffres et la distance minimale d₂,
(iii) obtenir ainsi un codage de la première information en un code produit C_{A} de n₁ x n₂ chiffres,
(iv) coder une deuxième information des r x kₓ chiffres où kₓ est inférieur à la longueur de code du deuxième code linéaire, en un troisième code linéaire de la distance minimale d₃, et
(v) produire un code composite en superposant un mot de code du troisième code linéaire sur un champ sur lequel est disposé le symbole de vérification dans la première ou la deuxième direction du code produit,
caractérisé en ce que
le nombre de chiffres r est inférieur au nombre de chiffres du symbole de vérification dans la première direction.

2. Procédé de décodage à correction d'erreurs pour décoder un mot de code d'un code composite créé en
codant, dans une première direction, une première information de k₁ x k₂ chiffres ayant k₁ chiffres dans la première direction et k₂ chiffres dans une deuxième direction en un premier code linéaire (n₁, k₁, d₁) ayant un symbole de vérification de (n₁ - k₁) chiffres et la distance minimale d₁,
codant le premier code linéaire dans la deuxième direction en un deuxième code linéaire ayant un symbole de vérification de (n₂ - k₂) chiffres et la distance minimale d₂,
ayant ainsi pour résultat un codage de la première information en un code produit C_{A} de n₁ x n₂ chiffres,
codant une deuxième information des r x kₓ chiffres où r est inférieur au nombre de chiffres du symbole de vérification dans la première direction et où kₓ est inférieur à la longueur de code du deuxième code linéaire, en un troisième code linéaire de la distance minimale d₃, et
superposant un mot de code du troisième code linéaire sur un champ sur lequel est disposé le symbole de vérification dans la première ou deuxième directions du code produit,
consistant à recevoir le mot de code comme mot reçu, décoder le code composite dans la première direction pour émettre le troisième code linéaire, décoder le troisième code linéaire pour émettre la deuxième information, et décoder le premier code linéaire dans la première direction pour émettre la première information.

3. Procédé de décodage selon la revendication 2, dans lequel le mot de code du code composite dans la première direction est décodé en considérant les chiffres sur lesquels le mot de code du troisième code linéaire est superposé comme des chiffres d'élimination, et en obtenant un motif récupéré d'élimination/d'erreur.

4. Procédé de codage et de décodage à correction d'erreurs, comprenant
le procédé de codage de la revendication 1 et le procédé de décodage de la revendication 2 ou 3.

5. Codeur pour mettre en oeuvre le procédé de codage de la revendication 1, comprenant
un premier module de codage (4) pour coder une première information de k₁ x k₂ chiffres ayant k₁ chiffres dans la première direction et k₂ chiffres dans la deuxième direction en un premier code linéaire ayant le symbole de vérification de (n₁ - k₁) chiffres avec la distance minimale d₁,
un deuxième module de codage (15) pour coder le premier code linéaire, dans la deuxième direction, en le deuxième code linéaire ayant le symbole de vérification de (n₂ - k₂) chiffres avec la distance minimale d₂, codant ainsi la première information en un code produit de n₁ x n₂ chiffres,
le codeur comprenant en outre un troisième module de codage (16) pour coder la deuxième information de r x kₓ chiffres qui est un produit du nombre de chiffres r et du nombre de chiffres kₓ qui est inférieur à la longueur de code du deuxième code linéaire, en le troisième code linéaire avec la distance minimale d₃, et
un circuit de commande de codage (3) pour produire un code composite en superposant un mode de code du troisième code linéaire sur un champ sur lequel est disposé le symbole de vérification dans la première direction du code produit,
caractérisé en ce que le nombre de chiffres r est inférieur au nombre de chiffres du symbole de vérification dans la première direction.

6. Décodeur pour mettre en oeuvre le procédé de décodage de la revendication 2 pour décoder un mot de code d'un mot composite créé en
codant, dans une première direction, une première information de k₁ x k₂ chiffres ayant k₁ chiffres dans la première direction et k₂ chiffres dans une deuxième direction en un premier code linéaire (n₁, k₁, d₁) ayant un symbole de vérification de (n₁ - k₁) chiffres et la distance minimale d₁,
codant le premier code linéaire dans la deuxième direction en un deuxième code linéaire ayant un symbole de vérification de (n₂ - k₂) chiffres et la distance minimale d₂,
ayant ainsi pour résultat un codage de la première information en un code produit C_{A} de n₁ x n₂ chiffres,
codant une deuxième information des r x kₓ chiffres où r est inférieur au nombre de chiffres du symbole de vérification dans la première direction et où kₓ est inférieur à la longueur de code du deuxième code linéaire, en un troisième code linéaire de la distance minimale d₃, et
superposant un mot de code du troisième code linéaire sur un champ sur lequel est disposé le symbole de vérification dans la première ou deuxième directions du code produit,
le décodeur comprenant
un premier module de décodage (14) qui reçoit un mot de code du code composite comme mot reçu pour décoder le code du code composite dans la première direction de manière à émettre un mot reçu du troisième code linéaire,
un troisième module de décodage (16) qui décode la deuxième information à partir du mot reçu du troisième code linéaire émis ou du motif récupéré d'élimination/d'erreur, et
un deuxième module de décodage (15) qui décode la première information à partir de la sortie de décodage du premier module de décodage.

7. Système de codage et de décodage à correction d'erreurs, comprenant
un codeur selon la revendication 5 et un décodeur selon la revendication 6.
